# FASCICULE DE BREVET EUROPEEN

(11) **EP 2 807 568 B1**
(45) Date de publication et mention de la délivrance du brevet: **03.04.2019**
(21) Numéro de dépôt: 13702618.3
(22) Date de dépôt: 27.01.2013
(51) Int. Cl.: G06F 9/38, G06F 12/0844, G06F 12/0855, G06F 12/06, G06F 13/16, G11C 7/10

(54) **PROCÉDÉ DE GESTION DE REQUÊTES D'ACCÈS À DES MÉMOIRES ET SYSTÈME DE STOCKAGE DE DONNÉES**
VERFAHREN ZUR VERWALTUNG VON SPEICHERZUGRIFFSANFORDERUNGEN UND DATENSPEICHERSYSTEM
METHOD OF MANAGING REQUESTS FOR ACCESS TO MEMORIES AND DATA STORAGE SYSTEM

(30) Priorité: 27.01.2012 FR 1200248
(43) Date de publication de la demande: 03.12.2014
(73) Titulaire: Simpulse, 91460 Marcoussis (FR)
(72) Inventeur: DE MARCHI, Stéphane, F-75014 Paris (FR); HAMMAN, Emmanuel, F-91460 Marcoussis (FR)
(74) Mandataire: Audic, Hervé
(86) Numéro de dépôt international: PCT/EP2013/051523
(87) Numéro de publication internationale: WO 2013/110802

(56) Documents cités:
- US-A1- 2004 088 516
- US-B1- 6 788 585
- REISIS D ET AL: "Conflict-Free Parallel Memory Accessing Techniques for FFT Architectures", IEEE TRANSACTIONS ON CIRCUITS AND SYSTEMS I: REGULAR PAPERS, IEEE, US, vol. 55, no. 11, 1 décembre 2008 (2008-12-01), pages 3438-3447, XP011333311, ISSN: 1549-8328, DOI: 10.1109/TCSI.2008.924889
- KUUSILINNA K ET AL: "Configurable parallel memory architecture for multimedia computers", JOURNAL OF SYSTEMS ARCHITECTURE, ELSEVIER BV, NL, vol. 47, no. 14-15, 1 août 2002 (2002-08-01), pages 1089-1115, XP004375023, ISSN: 1383-7621, DOI: 10.1016/S1383-7621(02)00059-0

## Description

La présente invention concerne un procédé de gestion de requêtes d'accès à des mémoires et un système de stockage de données.

Il existe des processeurs travaillant sur plusieurs données en parallèle, comme par exemple les processeurs de signaux numériques (« Digital Signal Processor » ou DSP en anglais), les processeurs à une seule instruction sur des données multiples (« Single Instructions on Multiple Data » ou SIMD en anglais), les processeurs à instructions longues (« Long Instruction Word » ou LIW en anglais), ou les processeurs vectoriels, c'est-à-dire conçus pour effectuer des opérations sur plusieurs nombres (représentant des vecteurs ou des matrices) pendant un unique cycle d'horloge.

De tels processeurs ont besoin de pouvoir lire et écrire un ensemble de données au même moment le plus rapidement possible.

Ces données peuvent être stockées dans différentes mémoires qui doivent être utilisées au mieux afin de bénéficier d'un maximum d'accès haut débit.

Il est ainsi connu d'utiliser un système de stockage destiné à être cadencé par un signal d'horloge et comportant plusieurs mémoires.

Chaque mémoire comporte un certain nombre de ports d'entrée et de sortie. Chaque port d'entrée est destiné à recevoir une requête d'accès à l'un des emplacements de la mémoire, repéré par son adresse, appelée adresse locale, dans la mémoire. La mémoire est destiné à recevoir des requêtes locales à chaque cycle d'horloge et à y répondre en un nombre prédéterminé de cycles d'horloge. La mémoire est en outre destinée à présenter, à la fin de ce ou ces cycles d'horloge, les réponses éventuelles sur ses ports de sortie. Ainsi, une mémoire ne peut recevoir par cycle d'horloge qu'un nombre de requêtes locales limité, au plus égal au nombre de ports d'entrée de cette mémoire.

Un type de mémoire classique est par exemple une mémoire à accès direct (appelée « Random Access Memory » ou RAM en anglais) simple port (un port d'entrée et un port de sortie associé) ou double ports (deux ports d'entrée et deux ports de sortie associés).

Le système de stockage comporte par ailleurs des ports d'entrée et un ou plusieurs ports de sortie. Chaque port d'entrée est destiné à recevoir, à chaque cycle d'horloge, une requête d'accès à un emplacement de l'une des mémoires. Cette requête indique une adresse globale structurée comme si le système de stockage constituait une seule mémoire. Il est ainsi connu d'utiliser une fonction de correspondance qui associe chaque adresse globale à une des mémoires et à une adresse locale dans cette mémoire.

Il est possible qu'au cours d'un même cycle d'horloge, le système de stockage reçoive sur ses ports d'entrée un nombre de requêtes d'accès vers la même mémoire supérieur à ce que cette mémoire peut recevoir sur ses ports d'entrée. Il y a donc un conflit car la mémoire ne pourra pas recevoir toutes ces requêtes dans un même cycle d'horloge.

Il est donc nécessaire de mettre en oeuvre un procédé de gestion des requêtes efficaces pour diminuer la fréquence des conflits.

Il existe plusieurs publications décrivant des procédés de gestion de requêtes d'accès à des mémoires, parmi lesquelles :
- la thèse de Eero Aho intitulée « Design and Implementation of Parallel Memory Architectures », et publiée en 2006 dans Tampere University of Technology, Publication 641,
- l'article de Kimmo Kuusilinna et al. intitulé « Configurable parallel memory architecture for multimédia computers », et publié en 2002 dans Journal of Systems Architecture 47 (2002) 1089-1115, et
- l'article de Dionysios Reisis et al. intitulé « Conflict-Free Parallel Memory Accessing Techniques for FFT Architectures », et publié en 2008 dans IEEE Transactions on circuits and systems,I - Regular papers, vol. 55, n° 11, décembre 2008.

Ces procédés proposent tous d'optimiser la fonction de correspondance en fonction de la répartition prévisible des accès aux mémoires.

Ces procédés de gestion de requêtes présentent comme problème de ne pas être très efficaces pour les applications les plus complexes, telles que les transformées de Fourier rapides (« Fast Fourier Transform » ou FFT en anglais) avec un radix changeant dans le temps en fonction de la taille des vecteurs sur lesquels la FFT est calculée, ou bien les applications où les accès se font à des emplacements aléatoires ou presque aléatoires. Ainsi, les accès aux mémoires sont difficilement prévisibles de sorte qu'il n'est pas possible d'optimiser la fonction de correspondance.

Ainsi, il peut être souhaité de disposer d'un procédé de gestion de requêtes permettant de diminuer la fréquence des conflits même dans le cas d'applications où les accès aux mémoires sont difficilement prévisibles.

Par ailleurs, le document US 6 788 585 B1 décrit une matrice mémoire comportant une horloge, une porte de commande d'amplificateur de détection et un amplificateur de détection. La matrice mémoire reçoit une requête depuis un processeur et cette requête est transmise à la matrice mémoire. La porte de commande d'amplificateur de détection utilise une entrée d'activation de lecture pour sélectivement activer ou désactiver l'amplificateur de détection afin de commander si de nouvelles données lues se propagent depuis la matrice mémoire.

Le document US 2004 088516 A1 décrit un procédé autorisant le traitement de multiples requêtes de lecture ou d'écriture dans un même cycle d'horloge.

L'invention est exposée dans les revendications indépendantes annexées. Des modes de réalisation avantageux sont définis par les revendications dépendantes annexées. Les modes de réalisation ou exemples de la description qui ne sont pas couverts par les revendications sont considérés comme ne faisant pas partie de l'invention selon cette description.

Des exemples de mise en oeuvre de l'invention vont à présent être décrits en référence aux figures suivantes :
- la figure 1 est une vue simplifiée d'un système de stockage conforme à l'invention, et
- la figure 2 est un schéma-blocs illustrant le déroulement des étapes d'un procédé de gestion de requêtes conforme à l'invention.

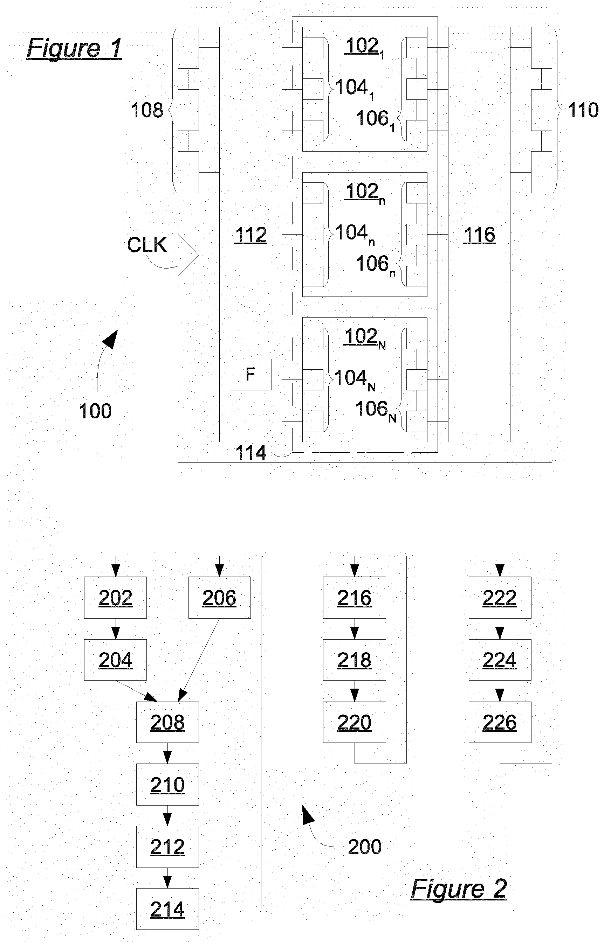

En référence à la figure 1, un système de stockage de données 100 conforme à l'invention va être à présent décrit.

Le système de stockage 100 comporte tout d'abord une entrée de signal d'horloge CLK destinée à recevoir un signal d'horloge de cadencement du système de stockage 100. Le signal d'horloge définit des cycles d'horloges successifs.

Le système de stockage 100 comporte en outre des mémoires 102ₙ (n = 1...N).

Chaque mémoire 102ₙ comporte un ou plusieurs ports d'entrée désignés globalement par la référence 104ₙ et un ou plusieurs ports de sortie désignés globalement par la référence 106ₙ.

Chaque port d'entrée 104ₙ de chaque mémoire 102ₙ est destiné à recevoir, à chaque cycle d'horloge, au plus une requête d'accès à la mémoire 102ₙ. Cette requête est sous la forme d'une requête locale indiquant en particulier une adresse de la mémoire 102ₙ où l'accès est destiné à être réalisé. Chaque port d'entrée 104ₙ est destiné à recevoir des requêtes d'accès en lecture et en écriture, ou bien spécialisé pour ne recevoir que des requêtes d'accès en lecture ou bien que des requêtes d'accès en écriture.

Chaque port de sortie 106ₙ de chaque mémoire 102ₙ est associé à un seul port d'entrée 104ₙ et est destiné à présenter, à chaque cycle d'horloge, au plus une réponse à une requête obtenue auprès du port d'entrée 104ₙ associé. Dans l'exemple décrit, seules les requêtes en lecture sont destinées à donner lieu à une réponse, mais pas les requêtes en écriture. Ainsi, un port de sortie 106ₙ est associé à chaque port d'entrée 104ₙ destiné à recevoir au moins des requêtes d'accès en lecture, mais il n'y a pas de port de sortie associé aux ports d'entrée 104ₙ spécialisés en écriture.

Chaque mémoire 102ₙ est ainsi destinée, à chaque cycle d'horloge, à obtenir des requêtes auprès de ses ports d'entrée 104ₙ, à les réaliser, et à fournir à ses ports de sortie 106ₙ les réponses éventuelles. Comme les ports d'entrée 104ₙ sont en nombre limité, chaque mémoire 102ₙ n'est apte à obtenir qu'un nombre limité de requêtes à chaque cycle d'horloge, ce qui sera appelé par la suite « capacité » de la mémoire.

En variante, la réalisation des requêtes prend plusieurs cycles d'horloge.

Le système de stockage 100 comporte en outre au moins deux ports d'entrée désignés globalement par le référence 108 et un ou plusieurs ports de sortie désignés globalement par la référence 110.

Chaque port d'entrée 108 est destiné à recevoir, à chaque cycle d'horloge, au plus une requête d'accès à une des mémoires 102ₙ. Cette requête est sous la forme d'une requête globale indiquant en particulier une adresse globale structurée comme si le système de stockage 100 était une seule mémoire. Chaque port d'entrée 108 est destiné à recevoir des requêtes d'accès en lecture et en écriture, ou bien spécialisé pour ne recevoir que des requêtes d'accès en lecture ou bien que des requêtes d'accès en écriture.

Chaque port de sortie 110 est associé à un seul port d'entrée 108 et est destiné à présenter, à chaque cycle d'horloge, au plus une réponse à une requête obtenue auprès du port d'entrée 108 associé. Dans l'exemple décrit, seules les requêtes en lecture sont destinées à donner lieu à une réponse, mais pas les requêtes en écriture. Ainsi, un port de sortie 110 est associé à chaque port d'entrée 108 destiné à recevoir au moins des requêtes d'accès en lecture, mais il n'y a pas de port de sortie associé aux ports d'entrée 108 spécialisés en écriture.

Le système de stockage 100 comporte en outre un ou plusieurs étages de traitement destinés à traiter successivement les requêtes obtenues auprès des ports d'entrée 108, à les réaliser et, le cas échéant, à fournir une réponse. Le ou les étages de traitement sont destinés à être successivement traversés de manière à former une ligne de traitement (traduction de l'anglais « *pipeline* »). De préférence, chaque étage de traitement est destiné à traiter les données qu'il reçoit en un cycle d'horloge. Ainsi, il est destiné à recevoir, à chaque cycle d'horloge, des données d'entrée et à fournir les données de sorties correspondant aux données d'entrée avant le cycle d'horloge suivant.

Dans l'exemple décrit, le système de stockage 100 comporte trois étages de traitement : un étage d'entrée 112 de traitement des requêtes, un étage intermédiaire 114 regroupant les mémoires 102ₙ et un étage de sortie 116 de traitement des réponses.

L'étage d'entrée 112 est destiné, à chaque cycle d'horloge, à réaliser les étapes qui seront détaillées en référence à la figure 2. En résumé, l'étage d'entrée 112 est destinée à obtenir des requêtes auprès des ports d'entrée 108, à en sélectionner certaines, et à fournir les requêtes sélectionnées à l'étage intermédiaire 114, c'est-à-dire aux ports d'entrée 104ₙ des mémoires 102ₙ. Les requêtes sont fournies sous la forme de requêtes locales indiquant une adresse locale dans la mémoire 102ₙ où la lecture ou l'écriture est destinée à être réalisée. L'étage d'entrée 112 comporte une fonction de correspondance F associant chaque adresse globale possible à une des mémoires 102ₙ et à une adresse locale dans cette mémoire 102ₙ.

L'étage de sortie 116 est destiné, à chaque cycle d'horloge, à réaliser les étapes qui seront détaillées en référence à la figure 2. En résumé, l'étage de sortie 116 est destiné à obtenir auprès des ports de sortie 106ₙ des mémoires 102ₙ les réponses éventuelles fournies par les mémoires 102ₙ, à déterminer, pour chaque réponse éventuelle, le port de sortie 110 sur lequel la réponse est destinée à être fournie, et à fournir cette réponse sur ce port de sortie 110.

De préférence, le système de stockage 100 est réalisé uniquement avec des composants matériels, et non avec des composants logiciels tels que des processeurs exécutant des instructions enregistrées sur un support de mémorisation.

En référence à la figure 2, un procédé de gestion de requêtes 200 conforme à l'invention et mis en oeuvre par le système de stockage 100 de la figure 1, va à présent être décrit.

À chaque cycle d'horloge, les étapes suivantes sont réalisées dans l'étage d'entrée 112.

Au cours d'une étape 202, s'il n'existait pas de requête prioritaire au cycle d'horloge précédent, l'étage d'entrée 112 obtient de nouvelles requêtes auprès des ports d'entrée 108. Comme cela sera expliqué par la suite, une requête prioritaire est une requête mise en attente à chacun des L derniers cycles d'horloge en partant du cycle d'horloge précédent, L étant un nombre prédéterminé supérieur ou égal à deux.

Au cours d'une étape 204, pour chaque nouvelle requête obtenue, l'étage d'entrée 112 détermine, au moyen de la fonction d'adressage F, la mémoire 102ₙ et l'adresse locale dans cette mémoire visées par la nouvelle requête.

Au cours d'une étape 206, s'il existait une ou plusieurs requêtes prioritaires au cycle d'horloge précédent, l'étage d'entrée 112 s'abstient d'obtenir de nouvelles requêtes.

Au cours d'une étape 208, l'étage d'entrée 112 sélectionne, parmi la ou les requêtes en attente éventuelles et la ou les nouvelles requêtes éventuelles, au moins une requête destinée à être fournie à l'étage intermédiaire 114. De préférence, la sélection d'au moins une requête est réalisée en fonction de la capacité de chaque mémoire 102ₙ à obtenir des requêtes. En particulier, pour chaque mémoire 102ₙ, un nombre de requêtes inférieur ou égal au nombre de port d'entrée 104ₙ de la mémoire 102ₙ est sélectionné. De préférence, la sélection est réalisée de manière à sélectionner le plus grand nombre possible de requêtes que la mémoire sera apte à recevoir au cycle d'horloge suivant. De préférence, la sélection d'au moins une requête est réalisée en donnant la priorité aux requêtes en attente les plus anciennes, c'est-à-dire aux requêtes mises en attente depuis le plus grand nombre de cycles d'horloge.

Dans le cas où il n'y a pas de requête en attente, l'étage d'entrée 112 sélectionne donc au moins une nouvelle requête.

Dans le cas où il y avait des requêtes prioritaires au cycle d'horloge précédent, l'étage d'entrée 112 sélectionne donc au moins une requête en attente et aucune nouvelle requête (puisqu'aucune nouvelle requête n'a été reçue au cycle d'horloge en cours).

Au cours d'une étape 210, l'étage d'entrée 112 fournit chaque requête sélectionnée à un port d'entrée 104ₙ de la mémoire 102ₙ visée par cette requête. La requête est fournie sous la forme d'une requête locale indiquant en particulier l'adresse locale visée.

Au cours d'une étape 212, l'étage d'entrée 112 met en attente la ou les requêtes non sélectionnées.

En particulier, dans le cas où une nouvelle requête n'a pas été sélectionnée, cette nouvelle requête est mise en attente.

Au cours d'une étape 214, l'étage d'entrée 112 détermine l'existence ou non d'au moins une requête mise en attente depuis au moins L cycles d'horloge, y compris le cycle d'horloge en cours, c'est-à-dire mise en attente à chacun des L derniers cycles d'horloge, y compris le cycle d'horloge en cours. L est un nombre prédéterminé supérieur ou égal à deux. Une telle requête est qualifiée de prioritaire. Le système de stockage 100 se trouve alors dans une situation dite de conflit. Dans ce cas, l'étage d'entrée 112 suspend l'obtention de nouvelles requêtes pour le cycle d'horloge suivant. De préférence, l'étage d'entrée 112 prévient en outre le dispositif informatique (non représenté) fournissant les requêtes au système de stockage 100 de cette situation de conflit, afin que ce dernier, par exemple, suspende l'envoi de requêtes au système de stockage 100 pour le cycle d'horloge suivant.

Parallèlement, les étapes suivantes sont réalisées dans l'étage intermédiaire 114.

Au cours d'une étape 216, chaque mémoire 102ₙ obtient sur ses ports d'entrée 104ₙ les requêtes qui lui ont été fournies au cycle précédent sous forme de requête locale par l'étage d'entrée 112.

Au cours d'une étape 218, chaque mémoire 102ₙ traite les requêtes qu'elle a obtenues. En particulier, dans le cas d'une requête d'accès en écriture indiquant des données à écrire, la mémoire 102ₙ écrit ces données à l'adresse locale. Dans le cas d'une requête en lecture, la mémoire 102ₙ lit les données se trouvant à l'adresse locale.

Au cours d'une étape 220, chaque mémoire 102ₙ fournit les réponses éventuelles sur ses ports de sortie 106ₙ. En particulier, dans le cas d'une requête d'accès en lecture, la mémoire 102ₙ fournit les données lues sur son port de sortie 106ₙ associé au port d'entrée 104ₙ sur lequel la requête a été obtenue.

Parallèlement, les étapes suivantes sont réalisées dans l'étage de sortie 116.

Au cours d'une étape 222, l'étage de sortie 116 obtient, auprès des ports de sortie 106ₙ des mémoires 102ₙ, les réponses éventuelles fournies par les mémoires 102ₙ.

Au cours d'une étape 224, l'étage de sortie 116 détermine, pour chaque réponse éventuelle, le port de sortie 110 sur lequel la réponse est destinée à être fournie.

Au cours d'une étape 226, l'étage de sortie 116 fournit chaque réponse sur le port de sortie 110 associé au port d'entrée 108 sur lequel la requête correspondant à cette réponse a été reçue.

Un exemple de fonctionnement du système de stockage 100 mettant en oeuvre le procédé de gestion 200 va à présent être décrit.

Dans cet exemple, le système de stockage 100 comporte trois ports d'entrée 108 (destinés à recevoir des requête d'accès en lecture et en écriture).

Le système de stockage 100 comporte en outre trois mémoires 102ₙ (N = 3) simple port, c'est-à-dire présentant chacune un seul port d'entrée 104ₙ et un seul port de sortie 106ₙ associé.

En outre, le nombre prédéterminé L vaut deux, de sorte qu'une requête mise en attente deux cycles d'horloge de suite devient prioritaire et entraîne l'arrêt de l'obtention de nouvelles requêtes.

Pour décrire cet exemple, un tableau récapitulatif sera présenté pour chaque cycle d'horloge.

La case de gauche de la première ligne du tableau indique les nouvelles requêtes obtenues sur les ports d'entrée 108 au cycle d'horloge en cours.

La case de droite de la première ligne du tableau indique les requêtes restant en attente, c'est-à-dire mises en attente au cycle d'horloge précédent le cycle d'horloge en cours.

La case de droite de la seconde ligne du tableau indique les requêtes sélectionnées au cycle d'horloge en cours pour être fournies à l'étage intermédiaire 114.

La case de gauche de la seconde ligne du tableau indique les requêtes mises en attente au cycle d'horloge en cours. Une requête déterminée comme prioritaire à la fin du cycle d'horloge en cours est indiquée par un soulignement.

Les requêtes sont notées sous la forme : Xy(n) où X est une lettre correspondant au port d'entrée (A pour le premier port, B pour le second et C pour le troisième), y est le numéro de la requête et n est l'indice de la référence de la mémoire 102ₙ visée par la requête.

### Premier cycle d'horloge

| | |
|---|---|
| A1(1), B1(1), C1(2) | - |
| A1(1), C1(2) | B1(1) |

Ainsi, au premier cycle d'horloge, l'étage d'entrée 112 obtient de nouvelles requêtes, en fournit deux nouvelles requêtes à l'étage intermédiaire et met en attente une nouvelle requête.

### Deuxième cycle d'horloge

| | |
|---|---|
| A2(1), B2(1), C2(3) | B1(1) |
| B1 (1), C2(3) | A2(1), B2(1) |

Ainsi, au deuxième cycle d'horloge, l'étage d'entrée 112 obtient de nouvelles requêtes, sélectionne deux requêtes parmi les nouvelles requêtes et la requête en attente et fournit ces deux requêtes. L'une des deux requêtes sélectionnées est une nouvelle requête obtenue au deuxième cycle d'horloge.

### Troisième cycle d'horloge

| | |
|---|---|
| A3(2), B3(3), C3(3) | A2(1), B2(1) |
| A2(1), A3(2), B3(3) | B2(1), C3(3) |

Ainsi, au troisième cycle d'horloge, l'étage d'entrée 112 détermine l'existence d'une requête prioritaire.

### Quatrième cycle d'horloge

| | |
|---|---|
| - | B2(1), C3(3) |
| B2(1), C3(3) | - |

Ainsi, au quatrième cycle d'horloge, l'étage d'entrée suspend l'obtention de nouvelles requêtes, et fournit la requête prioritaire ainsi qu'une requête non prioritaire.

### Cinquième cycle d'horloge

| | |
|---|---|
| A5(3), B5(2), C5(3) | - |
| B5(2), A5(3) | C5(3) |

Pour illustrer encore les résultats qui peuvent être obtenus par le système de stockage 100 et le procédé de gestion 200, il a été calculé le ratio entre, d'une part, le nombre de cycles d'horloge où aucune nouvelle requête n'est obtenue à cause de la présence d'au moins requête prioritaire au cycle d'horloge précédent et, d'autre part, le nombre de cycles d'horloge où des nouvelles requêtes sont obtenues à cause de l'absence de requête prioritaire au cycle d'horloge précédent. Le ratio a été calculé pour plusieurs valeurs du nombre prédéterminé L, dans le cas où les requêtes ciblent de manière aléatoires les mémoires 106ₙ, et où le système de stockage 100 comporte trente-deux ports d'entrée 108 et quarante-huit mémoires 102ₙ (N = 48) simple port.

Les résultats obtenus sont résumés dans le tableau suivant.

| **L** | **ratio** |
|---|---|
| 1 | 1,78 |
| 2 | 1,14 |
| 3 | 0,62 |
| 4 | 0,3 |
| 5 | 0,14 |

L'invention n'est pas limitée aux exemples de mise en oeuvre décrits précédemment, mais au contraire définie par les revendications qui suivent.

## Revendications

1. Procédé de gestion de requêtes reçues par un système de stockage (100) comportant des mémoires (102ₙ) comportant chacune un ou plusieurs ports d'entrée (104ₙ) et un ou plusieurs ports de sortie (106ₙ), une entrée (CLK) destinée à recevoir un signal d'horloge définissant des cycles d'horloge successifs, et un étage de traitement (112), le système de stockage (100) étant destiné recevoir des requêtes requérant chacune un accès à un emplacement de l'une des mémoires (102ₙ), le procédé comportant, à un premier cycle d'horloge :
- l'obtention (202) de nouvelles requêtes par l'étage de traitement (112),
- la fourniture (210) par l'étage de traitement (112) d'au moins une des nouvelles requêtes,
- la mise en attente (212) par l'étage de traitement (112) d'au moins une autre des nouvelles requêtes, appelée par la suite requête en attente,
le procédé étant **caractérisé en ce qu'**il comporte, à un second cycle d'horloge succédant au premier cycle d'horloge :
- l'obtention (202) par l'étage de traitement (112) d'au moins une nouvelle requête,
- la sélection (208) par l'étage de traitement (112), parmi la ou les requêtes en attente et la ou les nouvelles requêtes, d'au moins une requête,
- la fourniture (210) par l'étage de traitement de la ou des requêtes sélectionnées,
et **en ce qu'**il comporte en outre :
- la détermination (214) de l'existence ou non d'une requête mise en attente à chacun des L cycles d'horloge précédant le cycle d'horloge en cours, L étant un nombre prédéterminé supérieur ou égal à deux, une telle requête étant appelée requête prioritaire.
lorsque l'existence d'au moins une requête prioritaire est déterminée, la suspension d'obtention de nouvelles requêtes par l'étage de traitement (112) pour le cycle d'horloge en cours
et dans lequel l'obtention (202) par l'étage de traitement (112) d'au moins une nouvelle requête est réalisée lorsque l'existence d'aucune requête prioritaire est déterminée.

2. Procédé selon la revendication 1, dans lequel les requêtes sont fournies par l'étage de traitement (112) à un étage de traitement suivant (114) dans le système de stockage (100).

3. Procédé selon la revendication 2, dans lequel l'étage de traitement suivant (114) comporte les mémoires (102ₙ).

4. Procédé selon l'une des revendications 1 à 3, dans lequel la sélection (208) par l'étage de traitement (112) d'au moins une requête comporte la sélection d'une requête en attente.

5. Procédé selon l'une des revendications 1 à 4, dans lequel la sélection (208) par l'étage de traitement (112) d'au moins une requête comporte la sélection d'une nouvelle requête obtenue au second cycle d'horloge.

6. Procédé selon l'une des revendications 1 à 5, dans lequel, pour au moins une mémoire (102ₙ), la sélection d'au moins une requête destinée à être fournie à cette mémoire est réalisée de manière à sélectionner le plus grand nombre possible de requêtes que la mémoire sera apte à recevoir au cycle d'horloge suivant.

7. Procédé selon l'une des revendications 1 à 6, dans lequel, pour au moins une mémoire (102ₙ), la sélection d'au moins une requête destinée à être fournie à cette mémoire est réalisée en donnant la priorité aux requêtes mises en attente depuis le plus grand nombre de cycles d'horloge.

8. Système de stockage de données (100) comportant :
- des mémoires (102ₙ) comportant chacune un ou plusieurs ports d'entrée (104ₙ) et un ou plusieurs ports de sortie (106ₙ), le système de stockage (100) étant destiné recevoir des requêtes requérant chacune un accès à un emplacement de l'une des mémoires (102ₙ)
- une entrée (CLK) destinée à recevoir un signal d'horloge définissant des cycles d'horloge successifs,
- un étage de traitement (112) destiné, à un premier cycle d'horloge, à :
- obtenir de nouvelles requêtes,
- fournir au moins une des nouvelles requêtes,
- mettre en attente au moins une autre des nouvelles requêtes, appelée par la suite requête en attente,
le système de stockage (112) étant **caractérisé en ce que** l'étage de traitement est en outre destiné, à un second cycle d'horloge succédant au premier cycle d'horloge, à :
- obtenir au moins une nouvelle requête,
- sélectionner, parmi la ou les requêtes en attente et la ou les nouvelles requêtes, au moins une requête destinée à être fournie,
- fournir la ou les requêtes sélectionnées,
et **en ce que** l'étage de traitement est en outre destiné à :
- déterminer (214) l'existence ou non d'une requête mise en attente à chacun des L cycles d'horloge précédant le cycle d'horloge en cours, L étant un nombre prédéterminé supérieur ou égal à deux, une telle requête étant appelée requête prioritaire, lorsque l'existence d'au moins une requête prioritaire est déterminée, la suspension d'obtention de nouvelles requêtes par l'étage de traitement (112) pour le cycle d'horloge en cours
et dans lequel l'obtention (202) par l'étage de traitement (112) d'au moins une nouvelle requête est réalisée lorsque l'existence d'aucune requête prioritaire est déterminée.

## Patentansprüche

1. Verfahren zur Verwaltung von Anforderungen, erhalten von einem Speichersystem (100), aufweisend Speicher (102ₙ), die jeweils einen oder mehrere Eingangsports (104ₙ) und einen oder mehrere Ausgangsports (106ₙ) aufweisen, einen Eingang (CLK), der zum Empfangen eines Zeitsignals bestimmt ist, das aufeinanderfolgende Zeitzyklen festlegt, und eine Verarbeitungsstufe (112), wobei das Speichersystem (100) zum Empfangen von Anforderungen bestimmt ist, die jeweils einen Zugriff auf eine Stelle einer der Speicher (102ₙ) anfordern, wobei das Verfahren bei einem ersten Zeitzyklus aufweist:
- Erhalten (202) neuer Anforderungen durch die Verarbeitungsstufe (112),
- Bereitstellen (210), durch die Verarbeitungsstufe (112), von mindestens einer der neuen Anforderungen,
- Versetzen in Warteposition (212), durch die Verarbeitungsstufe (112), von mindestens einer anderen der neuen Anforderungen, im Folgenden Anforderung in Warteposition genannt,
wobei das Verfahren **dadurch gekennzeichnet ist, dass** es bei einem zweiten Zeitzyklus, der dem ersten Zeitzyklus folgt, aufweist:
- Erhalten (202), durch die Verarbeitungsstufe (112), von mindestens einer neuen Anforderung,
- Auswählen (208), durch die Verarbeitungsstufe (112), aus der oder den Anforderungen in Warteposition und der oder den neuen Anforderungen mindestens einer Anforderung,
- Bereitstellen (210), durch die Verarbeitungsstufe, der ausgewählten Anforderung(en),
und dadurch, dass es ferner aufweist:
- Ermitteln (214) des Vorhandenseins oder nicht einer in Warteposition versetzten Anforderung bei jedem der L Zeitzyklen vor dem laufenden Zeitzyklus, wobei L eine bestimmte Anzahl größer oder gleich zwei ist, wobei eine derartige Anforderung prioritäre Anforderung genannt wird,
wenn das Vorhandensein von mindestens einer prioritären Anforderung ermittelt ist, das Aussetzen des Erhaltens von neuen Anforderungen durch die Verarbeitungsstufe (112) für den laufenden Zeitzyklus
und wobei das Erhalten (202), durch die Verarbeitungsstufe (112), von mindestens einer neuen Anforderung durchgeführt wird, wenn das Vorhandensein keiner neuen prioritären Anforderung ermittelt ist.

2. Verfahren nach Anspruch 1, wobei die Anforderungen durch die Verarbeitungsstufe (112) einer folgenden Verarbeitungsstufe (114) in dem Speichersystem (100) bereitgestellt werden.

3. Verfahren nach Anspruch 2, wobei die folgende Verarbeitungsstufe (114) die Speicher (102ₙ) aufweist.

4. Verfahren nach einem der Ansprüche 1 bis 3, wobei das Auswählen (208), durch die Verarbeitungsstufe (112), von mindestens einer Anforderung das Auswählen einer Anforderung in Warteposition aufweist.

5. Verfahren nach einem der Ansprüche 1 bis 4, wobei das Auswählen (208), durch die Verarbeitungsstufe (112), von mindestens einer Anforderung das Auswählen einer neuen, im zweiten Zeitzyklus erhaltenen Anforderung aufweist.

6. Verfahren nach einem der Ansprüche 1 bis 5, wobei, für mindestens einen Speicher (102ₙ), das Auswählen von mindestens einer Anforderung, die zur Bereitstellung bei diesem Speicher bestimmt ist, derart durchgeführt wird, dass die größtmögliche Anzahl von Anforderungen ausgewählt wird, die der Speicher imstande ist, im nächsten Zeitzyklus zu empfangen.

7. Verfahren nach einem der Ansprüche 1 bis 6, wobei, für mindestens einen Speicher (102ₙ), das Auswählen von mindestens einer Anforderung, die zur Bereitstellung bei diesem Speicher bestimmt ist, durchgeführt wird, indem den seit der größten Anzahl von Zeitzyklen in Warteposition versetzten Anforderungen Priorität gegeben wird.

8. Datenspeichersystem (100) aufweisend:
- Speicher (102ₙ), die jeweils einen oder mehrere Eingangsports (104ₙ) und einen oder mehrere Ausgangsports (106ₙ) aufweisen, wobei das Speichersystem (100) zum Empfangen der Anforderungen bestimmt ist, die jeweils einen Zugriff auf eine Stelle einer der Speicher (102ₙ) anfordern,
- einen Eingang (CLK), der zum Empfangen eines Zeitsignals bestimmt ist, das aufeinanderfolgende Zeitzyklen festlegt,
- eine Verarbeitungsstufe (112), die bei einem ersten Zeitzyklus bestimmt ist:
- neue Anforderungen zu erhalten,
- mindestens eine der neuen Anforderungen bereitzustellen,
- mindestens eine andere der neuen Anforderungen, im Folgenden Anforderung in Warteposition genannt, in Warteposition zu versetzen,
wobei das Speichersystem (112) **dadurch gekennzeichnet ist, dass** die Verarbeitungsstufe ferner bestimmt ist, bei einem zweiten Zeitzyklus, der dem ersten Zeitzyklus folgt:
- mindestens eine neue Anforderung zu erhalten,
- aus der oder den Anforderungen in Warteposition und der oder den neuen Anforderungen mindestens eine Anforderung auszuwählen, die bestimmt ist, bereitgestellt zu werden,
- die ausgewählte(n) Anforderung(en) bereitzustellen,
und dadurch, dass die Verarbeitungsstufe ferner bestimmt ist, um:
- das Vorhandenseins oder nicht einer in Warteposition versetzten Anforderung bei jedem der L Zeitzyklen vor dem laufenden Zeitzyklus zu ermitteln (214), wobei L eine bestimmte Anzahl größer oder gleich zwei ist, wobei eine derartige Anforderung prioritäre Anforderung genannt wird,
wenn das Vorhandensein von mindestens einer prioritären Anforderung ermittelt ist, Aussetzen des Erhaltens von neuen Anforderungen durch die Verarbeitungsstufe (112) für den laufenden Zeitzyklus
und wobei das Erhalten (202), durch die Verarbeitungsstufe (112), von mindestens einer neuen Anforderung durchgeführt wird, wenn das Vorhandensein keiner prioritären Anforderung ermittelt ist.

## Claims

1. Method of managing requests received by a storage system (100) comprising memories (102ₙ) each comprising one or more input ports (104ₙ) and one or more output ports (106ₙ), an input (CLK) intended to receive a clock signal defining successive clock cycles, and a processing stage (112), the storage system (100) being intended to receive requests each requiring access to a location in one of the memories (102ₙ), the method comprising, in a first clock cycle:
- the obtaining (202) of new requests by the processing stage (112),
- the provision (210) by the processing stage (112) of at least one of the new requests,
- the placing on standby (212) by the processing stage (112) of at least one other of the new requests, hereinafter called the pending request,
the method being **characterised in that** it comprises, in a second clock cycle succeeding the first clock cycle:
- the obtaining (202) by the processing stage (112) of at least one new request,
- the selecting (208) by the processing stage (112), from among the one or more pending requests and the one or more new requests, of at least one request,
- the provision (210) by the processing stage of the one or more requests selected,
and **in that** it further comprises:
- the determining (214) of the existence or non-existence of a pending request at each of the L clock cycles preceding the current clock cycle, where L is a predetermined number greater than or equal to two, such a request being called a priority request,
when the existence of at least one priority request is determined, the suspension of obtaining new requests by the processing stage (112) for the current clock cycle
and wherein the obtaining (202) by the processing stage (112) of at least one new request is carried out when the existence of no priority request is determined.

2. Method according to claim 1, wherein the requests are provided by the processing stage (112) to a subsequent processing stage (114) in the storage system (100) .

3. Method according to claim 2, wherein the subsequent processing stage (114) comprises the memories (102ₙ).

4. Method according to one of claims 1 to 3, wherein the selecting (208) by the processing stage (112) of at least one request comprises selecting a pending request.

5. Method according to one of claims 1 to 4, wherein the selecting (208) by the processing stage (112) of at least one request comprises selecting a new request obtained in the second clock cycle.

6. Method according to one of claims 1 to 5 wherein, for at least one memory (102ₙ), the selecting of at least one request intended to be provided to said memory is carried out so as to select the highest possible number of requests that the memory is capable of receiving in the subsequent clock cycle.

7. Method according to one of claims 1 to 6 wherein, for at least one memory (102ₙ), the selecting of at least one request intended to be provided to said memory is carried out by giving priority to requests that have been pending for the highest number of clock cycles.

8. Data storage system (100) comprising:
- memories (102ₙ) each comprising one or more input ports (104ₙ) and one or more output ports (106ₙ), the storage system (100) being intended to receive requests each requiring access to a location in one of the memories (102ₙ)
- an input (CLK) intended to receive a clock signal defining successive clock cycles,
- a processing stage (112) intended, in a first clock cycle, to:
-- obtain new requests,
-- provide at least one of the new requests,
-- place on standby at least one other of the new requests, hereinafter called the pending request,
the storage system (112) being **characterised in that** the processing stage is further intended, in a second clock cycle succeeding the first clock cycle, to:
-- obtain at least one new request,
-- select, from among the one or more pending requests and the one or more new requests, at least one request intended to be provided,
-- provide the one or more selected requests,
and **in that** the processing stage is further intended to:
- determine (214) the existence or non-existence of a pending request at each of the L clock cycles preceding the current clock cycle, where L is a predetermined number greater than or equal to two, such a request being called a priority request,
when the existence of at least one priority request is determined, the suspension of obtaining new requests by the processing stage (112) for the current clock cycle
and wherein the obtaining (202) by the processing stage (112) of at least one new request is carried out when the existence of no priority request is determined.
